# EUROPEAN PATENT SPECIFICATION

(11) **EP 1 418 250 B1**
(45) Date of publication and mention of the grant of the patent: **19.12.2007**
(21) Application number: 03023892.7
(22) Date of filing: 21.10.2003
(51) Int. Cl.: C23C 14/24, H01L 51/40

(54) **Vacuum evaporator**
Vakuumverdampfer
Evaporateur sous-vide

(30) Priority: 21.10.2002 JP 2002305379
(43) Date of publication of application: 12.05.2004
(73) Proprietor: Tohoku Pioneer Corporation, Tendo-shi, Yamagata-ken (JP); Nippon Steel Chemical Co., Ltd., Tokyo 141-0031 (JP)
(72) Inventor: Sawada, Yasuhiko, Yonezawa-shi Yamagata-ken 992-1128 (JP); Yuki, Toshinao, Yonezawa-shi Yamagata-ken 992-1128 (JP); Murayama, Ryuji, Yonezawa-shi Yamagata-ken 992-1128 (JP); Ogoshi, Kunizo, Yonezawa-shi Yamagata-ken 992-1128 (JP); Ishii, Kazuo, 46-80, Sakinohama, Fukuoka-ken 804-0002 (JP)
(74) Representative: Sajda, Wolf E.

(56) References cited:
- EP-A- 0 454 009
- WO-A-01/79581
- US-A- 5 512 155
- PATENT ABSTRACTS OF JAPAN vol. 2002, no. 02, 2 April 2002 (2002-04-02) & JP 2001 273976 A (TOHOKU PIONEER CORP), 5 October 2001 (2001-10-05)
- PATENT ABSTRACTS OF JAPAN vol. 1999, no. 09, 30 July 1999 (1999-07-30) & JP 11 100663 A (NEC CORP), 13 April 1999 (1999-04-13)
- PATENT ABSTRACTS OF JAPAN vol. 012, no. 159 (C-495), 14 May 1988 (1988-05-14) & JP 62 270769 A (MITSUBISHI HEAVY IND LTD; others: 01), 25 November 1987 (1987-11-25)
- PATENT ABSTRACTS OF JAPAN vol. 017, no. 382 (C-1085), 19 July 1993 (1993-07-19) & JP 05 065641 A (CHUGAI RO CO LTD), 19 March 1993 (1993-03-19)
- PATENT ABSTRACTS OF JAPAN vol. 2000, no. 06, 22 September 2000 (2000-09-22) & JP 2000 087234 A (NAKADA TOKIO), 28 March 2000 (2000-03-28)

## Description

### BACKGROUND OF THE INVENTION

The present invention relates to a vacuum evaporator.

A vacuum evaporation is known as one of techniques to form a thin film on a substrate. The vacuum evaporation is a method for forming a thin film of a deposition material on a substrate in a vacuum tank, wherein the substrate is placed facing to an evaporation source, and an evaporation flow generated by heating of the evaporation source is applied to the surface of the substrate. A vacuum evaporator for the vacuum evaporation comprises the vacuum tank, the evaporation source, heating and evaporating means and a substrate holder as basic elements. The heating and evaporating means involve induction heating means which is composed of a vessel made of a material capable of producing heat upon electromagnetic induction to induction-heat the vessel, resistance heating means for evaporating a deposition material by the heat generated from flowing an electric current through a vessel which is made of a metallic material having comparatively higher resistance, and evaporating means with electron beam or laser beam for evaporating the deposition material by an energy caused of irradiating an electron beam or a laser beam directly to the deposition material in the evaporation source.

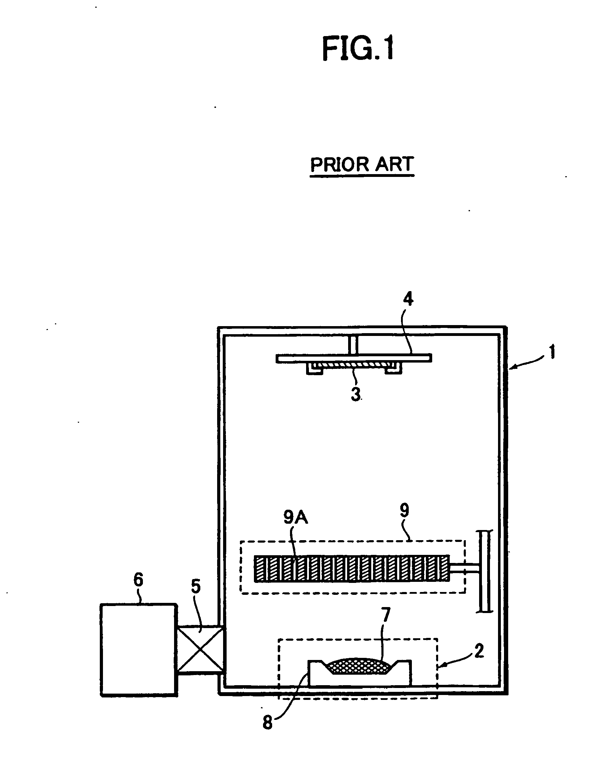

Fig. 1 is an explanatory view showing a conventional vacuum evaporator disclosed in Japanese Patent Application Laid open No. Hei 11-100663. This vacuum evaporator has an evaporation source 2 arranged at the bottom of a vacuum tank 1 and a substrate 3 fixed with a substrate holder 4 near the ceiling of the vacuum tank 1. The interior of the vacuum tank 1 is maintained in a vacuum state by a vacuum pump 6 connected to the vacuum tank 1 via a valve 5. The evaporation source 2 is composed of a vessel 8 receiving a deposition material 7, and the aforementiond heating and evaporating means for heating the vessel 8.

The conventional vacuum evaporator also has a collimator 9 disposed between the evaporation source 2 and substrate 3. The collimator 9 is a jig for passing through only evaporation flow going nearly straight towards the substrate or for suppressing the spreading of the evaporation flow. The jig has many through holes 9A formed parallel to a line connecting between the center of the evaporation source 2 and that of the substrate holder 3.

The conventional vacuum evaporator can control a direction of the evaporation flow by means of the collimator 9 disposed in evaporation flows, having an advantage of being capable of applying an evaporation flow perpendicular to a substrate.

However, the evaporation flow blocked by the collimator 9 without passing through the through hole 9A, is returned to the bottom of the vacuum tank 1, to be deposited thereon. Thus, the material evaporated from the evaporation source is used in only little amount thereof for forming a thin film on the substrate 3, and almost all the part of the material is abandoned without utilization. This causes a problem of little utilization of the deposition material. Furthermore there causes another problem of lowering the quality of the formed thin film as follow; when deposition s are carried out as a series of processes using different materials in the same vacuum tank, the residual material in the vacuum tank is mixed into the film of different materials as impurities, so that the quality of the formed thin film is lowered.

These problems are caused in forming a thin film by the vacuum evaporator, more particularly in a manufacture of an organic EL display panel, in which expensive organic materials are needed for forming multi organic light-emitting layers at every region of different color on the substrate.

In the conventional vacuum evaporator, as an evaporation flow spreads from the evaporation source 2 to a periphery thereof, an evaporation flow is blocked by the collimator 2. Therefore, the conventional vacuum evaporator also has a problem that uniform deposition is difficult for the entire surface of a large-area substrate, because a film thickness at the periphery of the substrate becomes thinner compared with that of a central part thereof.

### SUMMARY OF THE INVENTION

The present invention is to cope with the foregoing problems. That is, the objects of the present invention are to improve the utilization efficiency of deposition materials, to improve a quality of a thin film, and to perform uniform deposition even for a large-area substrate.

The first aspect according to the present invention is to provide a vacuum evaporator having an evaporation source formed out of consecutively stacked frames. The evaporation source comprises a heating part located in the lower frame for heating and evaporating organic material accommodated therein, and an evaporation flow controller located in the upper frame for controlling a direction of an evaporation flow from the evaporation source to a deposition object.

The second aspect according to the present invention is to provide a vacuum evaporator having an evaporation source formed out of consecutively stacked frames. The evaporation source comprises a heating part located in the lower frame for heating and evaporating organic material accommodated therein, and an evaporation flow controller located in the upper frame for controlling a direction of an evaporation flow from the evaporation source to a deposition object. Further, the evaporation flow controller is provided with a uniformizing layer for uniformizing the evaporation flow, which is located at the uppermost stream in the controller.

The third aspect according to the present invention is to provide a method of manufacturing an organic EL display panel with organic thin films deposited between a pair of electrodes, any one of which is formed on a surface of a substrate, through employing the respective vacuum evaporators according to the first and second aspects as mentioned above.

### BRIEF DESCRIPTION OF THE DRAWINGS

These and other objects and advantages of the present invention will become clear from the following description with reference to the accompanying drawings, wherein:
Fig. 1 is an explanatory view illustrating a conventional vacuum evaporator;
Fig. 2 is an explanatory view showing a vacuum evaporator according to the first embodiment of the present invention;
Fig. 3 is an explanatory view showing a vacuum evaporator according to the second embodiment of the present invention;
Fig. 4 is an explanatory view (partially cross-sectional view) explaining a vacuum evaporator according to an embodiment of the present invention;
Fig. 5A through Fig. 5E are explanatory views illustrating various examples of regulation layers for an evaporation flow in vacuum evaporators according to the embodiments of the present invention;
Fig. 6 is a view explaining the other example according to an embodiment of the present invention;
Fig.7A through Fig. 7D are explanatory views illustrating a more specific uniformizing layer according to an embodiment;
Fig. 8 is a cross-sectional view illustrating a distributing plate according to the embodiment;
Fig. 9 is an explanatory view illustrating the other embodiment of the present invention;
Fig. 10A and Fig. 10B are explanatory views illustrating an example of a vacuum evaporator for a large-area substrate using an evaporation source according to the embodiments of the present invention; and
Fig. 11 is an explanatory view illustrating another example of vacuum evaporator for a large-area substrate using an evaporation source according to the embodiments of the present invention.

### DETAILED DESCRIPTION OF THE PREFERRED EMBODIMENTS

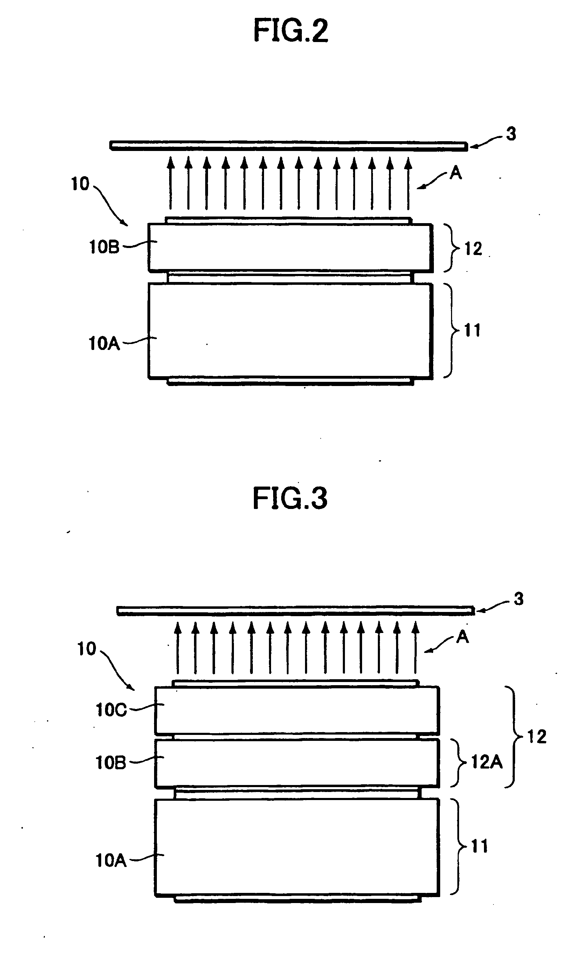

The following description will describe various embodiments of the present invention referring to the drawings. Fig. 2 and Fig. 3 are explanatory views explaining respectively a vacuum evaporator according to an embodiment of the present invention. These drawings illustrate, respectively, that a substrate 3 serving as a deposition object and an evaporation source 10 are placed in a vacuum tank (not shown in these drawings).

The first embodiment, as shown in Fig. 2, is characterized by providing an evaporation source composed of stacked frames 10A and 10B, wherein the lower frame 10A serves as a heating part 11 for accommodating an organic material and evaporating the organic material by heating, and the upper frame 10B serves as an evaporation flow controller 12 for controlling a direction of the evaporation flow from the heating part 11 to the deposition object (substrate 3).

In this embodiment, the evaporation flow controller 12 controls a direction of the evaporation flow of the organic material evaporated by the heating part 11. That is, only an evaporation flow passing through the evaporation flow controller 12 can reach the substrate 3. Because the organic material blocked by the evaporation flow controller 12 is confined in the stacked frames 10A and 10B, the blocked organic material can be collected into the lower frame 10A. This causes high-utilization of the organic material from the evaporation source. Furthermore, if a plurality of frames are further stacked to the existing frame structure, an emitting opening of an evaporation source can be brought near to the substrate, so that the evaporation flow going through the emitting opening can be effectively irradiated to the substrate.

The second embodiment, as shown in Fig. 3, is characterized by an evaporation source composed of a stacked frame structure, 10A 10B and 10C; wherein the lowest frame 10A serves as a heating part 11 for accommodating an organic material and evaporating the organic material by heating, and the other frames 10B and 10C serve as an evaporation flow controller 12 for controlling a direction of the evaporation flow from the heating part 11 to the deposition object (substrate 3). Furthermore, the evaporation flow controller 12 provides a uniformizing layer 12A for uniformizing the evaporation flow, at the location of uppermost stream.

Because the uniformizing layer 12A uniformizes the evaporation flow in the entire region from the heating part 11 to the substrate, this embodiment, in addition to the characteristics of the first embodiment, further enables a uniform formation of an evaporation film from its center to the periphery, even when the evaporation source 10 has a large-area emitting opening to be suitable for a large-area substrate.

The third embodiment is characterized by a uniformizing layer 12A being equipped with a distributing plate having a plurality of guide projections, which change a direction of an evaporation flow,and holesformed between the guide projections. An evaporation flow toward the uniformizing layer 12A are changed in direction by the inclined surfaces of guide projections and emitted from the holes to various directions, that is, the existance of guide projections can uniformize the density of the evaporation flow from its center to the periphery.

The fourth embodiment is characterized by a uniformizing layer 12A, whose frame is conical and which expands along the downstream direction of the evaporation flow, having a plurality of distributing plates arranged in multi stages. A multi-stage arrangement of distributing plates performing the function described above can achieve better uniformity of the evaporation flow. When it is necessary for the evaporation flow to extend its emitted region for evaporating a large-area substrate, the emitting opening can be extended, as keeping the opening of the heating part 11 smaller, through the inverted conical frame spreading along the downstream direction of the evaporation flow.

The fifth embodiment is characterized by a uniformizing layer 12A being formed out of a material capable of being heated by the heating means. The heating of the uniformizing layer 12A can improve a recovery percentage, to the heating part, of a deposition material adhered to the uniformizing layer 12A.

The sixth embodiment is characterized by an evaporation flow controller 12 involving an evaporation flow regulation layer having a plurality of passing zones sectioned by regulation plates. The evaporation flow regulation layer can regulate the evaporation flow for applying it to a substrate with a direction of a certain angle. The shape of the passing zone may be a stripe pattern, a grid pattern, a cylindrical structure, a cone structure or a honeycomb structure.

The seventh embodiment is characterized by an evaporation flow controller 12 involving heating means and the regulation plates, some of which are at least formed out of material capable of being heated by the heating means. The heating of the regulation plate can improve a recovery percentage of deposition materials because of reducing adhesion of a deposition material to the regulation plates by heating them.

The eighth embodiment is characterized by a heating part, which accommodates the above-mentioned organic material and fillers, at least one part of which is made of a material adapted to be heated by electromagnetic induction. The heating part also provides heating means for heating the fillers by electromagnetic induction. Because the fillers are arranged dispersively in the heating part, it becomes possible to uniformly heat the organic material in the heating part and to uniformize a distribution of an evaporation flow emitted from the heating part.

The ninth embodiment is characterized by a meshed big cluster of molecule capturing body 30 cable of being heated, placed between a heating part and an evaporation flow controller or between the respective layers of the evaporation flow controller. The meshed big cluster of molecule capturing body 30 heated with the heating means in the heating part can capture impurities, then it becomes possible to form a high-quality thin film of organic materials on a substrate.

The tenth embodiment is characterized by a planer arrangement of a plurality of the abovementioned evaporation sources. This enables a reduction in time needed for evaporation, because it becomes possible to form a thin film with a uniform thickness even on a larger-area substrate only by one process.

The eleventh embodiment is characterized by a linear arrangement of a plurality of the evaporation sources and transfer means for transferring any one of the aggregations of the evaporation sources or the substrate perpendicularly to the direction of the linear arrangement of the sources. This enables a reduction in time needed for evaporation, because it becomes possible to form a uniform thin film on a larger-area substrate by the process of transferring the transfer means.

The twelfth embodiment is characterized by an organic EL display panel manufactured with the vacuum evaporator having the above-mentioned features. In manufacture of an organic EL display panel, because of an effective utilization of high-cost organic materials forming different multi-layered organic emitting layer for each color, it becomes possible to reduce manufacturing costs. Furthermore, a uniform and high-qualitythinfilm manufacture causes a reduction in irregularities of emitted light and an extension of a lifetime of the display panel. Thus, it becomes possible to provide an organic EL display panel with high quality even on a large-area substrate.

The thirteenth embodiment is characterized by using the vacuum evaporator according to the first embodiment, for manufacture of an organic EL display panel which is formed out of organic thin films between a pair of electrodes, one of which is formed on a surface of a substrate.

In this vacuum evaporator, an evaporation flow of an organic material evaporated from a heating part 11 is controlled in the direction with an evaporation flow controller 12, and only the evaporation flow A passing through the controller can reach the substrate 3. The organic material blocked by the evaporation flow controller 12 does not go out from the stacked frames 10A, 10B, but is recovered into the bottom frame 10A. This causes high-utilization of the organic material evaporated from the evaporation source. Furthermore, if a plurality of frames are further stacked to the existing frame structure, an emitting opening of an evaporation source can be brought near to the substrate, so that the evaporation flow emitted through the emitting opening can be effectively irradiated to the substrate. Consequently, an effective manufacturing of an organic EL display panel is enabled.

The fourteenth embodiment is characterized by using the vacuum evaporator according to the second embodiment, for manufacturing an organic EL display panel formed out of organic thin films between a pair of electrodes one of which is formed on a surface of a substrate.

Because the uniformizing layer 12A uniformizes the evaporation flow in the entire region from the heating part 11 to the substrate, this embodiment further enables a uniform formation of an evaporation film from its center to the periphery, even when the evaporation source 10 has a large-area opening to be suitable to a large-area substrate. Thus, this enables manufacturing an organic EL display panel on a large-area substrate effectively and uniformly.

The fifteenth embodiment is concerned with a method of manufacturing an organic display panel characterized by using a vacuum evaporator having properties described as the eighth embodiment. The eighth embodiment provides the heating part, wherein the heating part accommodates the above-mentioned organic material and fillers, at least one part of which is made of a material capable of being heated by electromagnetic induction, and the heating part also provides heating means for heating the fillers by electromagnetic induction. Because the fillers are accommodated dispersively in the heating part, it becomes possible to uniformly heat the organic material in the heating part and to uniformize a distribution of an evaporation flow emitted from the heating part. Thus, the manufacture of an organic EL display panel with high quality is enabled.

The following description will describe more specific embodiments of the present invention referring to drawings.

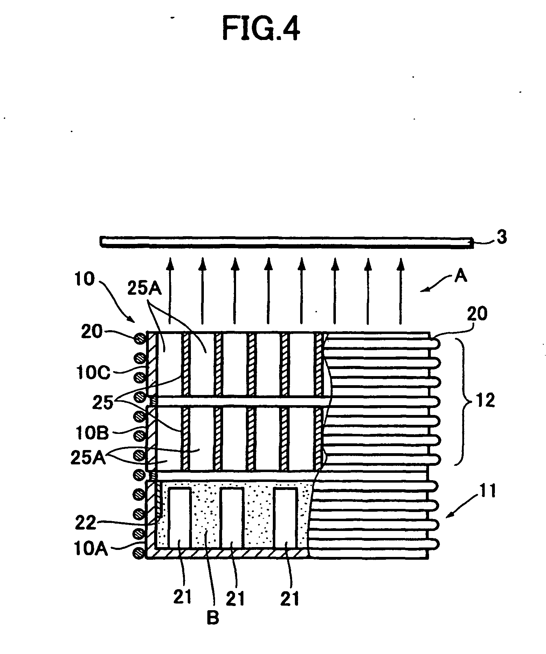

Fig. 4 is a partially cross-sectional view explaining a vacuum evaporator according to an embodiment of the present invention. This figure shows an evaporation source 10 disposed face to face with a substrate 3 in a vacuum tank (not shown in this figure). In this embodiment, the evaporation source 10 is composed of three stacked frames 10A, 10B and 10C. A heating coil 20 is wound around these frame structures. The bottom frame 10A serves as a heating part 11 and the upper stacked frames 10B and 10C serve as an evaporation flow controller 12.

The frame 10A of the heating part 11 comprises a vessel for accommodating an organic material B used as a deposition material, the organic material B, and fillers 21, disposed in the vessel, formed out of a material capable of producing heat by electromagnetic induction. A magnetic probe 22 is provided inside the frame 10A for monitoring the temperature of the frame 10A. The fillers 21 are formed out of materials including ferromagnetic metal substance, such as nickel, iron, magnetic stainless steel or cobalt-nickel alloy, particularly in view of thermal resistance and corrosion prevention, stainless steel, graphite or magnetic ceramics such as titanium nitride can be used. The frame 10A is formed out of nonconductive and nonmagnetic material such as ceramics, glass, porcelain enamel or thermal resistive resin. When an induction heating is used as heating means, the frame 10A is preferably cylindrical in shape to supply a uniform magnetic field to fillers 21 for producing heat.

The evaporation flow controller 12 is composed of the frames 10B and 10C, which have passing zones 25A sectioned by regulation plates 25 in their insides to serve as an evaporation flow regulation layer. The regulation plates 25 are formed out of such material producing heat by electromagnetic induction as described above, and the frames 10B and 10C may be formed out of nonconductive and nonmagnetic material as described above, or the frames 10B and 10C themselves may be formed out of material producing heat by electromagnetic induction.

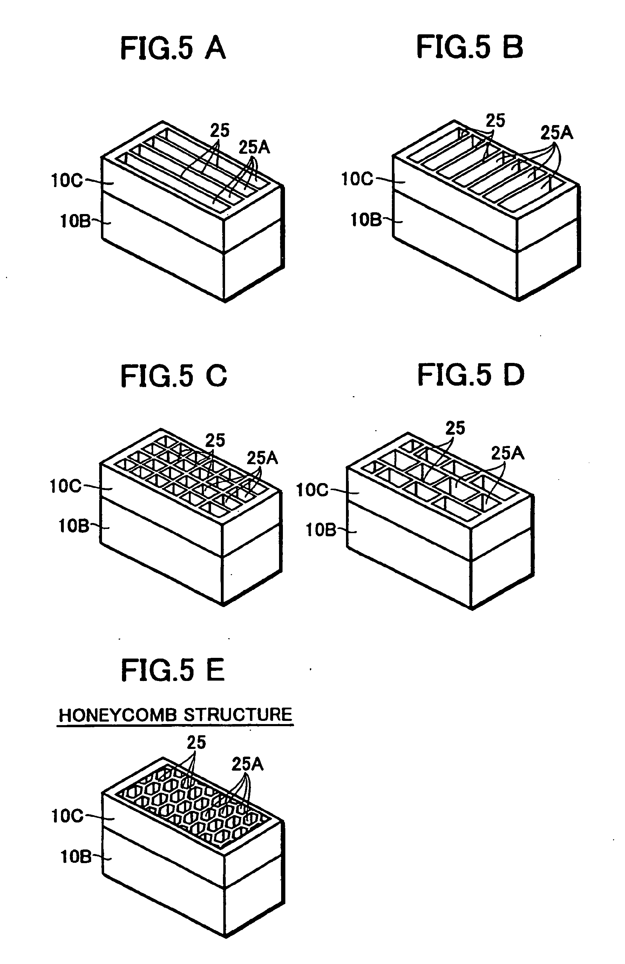

The plurality of passing zones 25A of the evaporation flow regulation layer may be formed in various forms as shown in Fig. 5. An example in Fig. 5A shows rectangular-shaped passing zones 25A sectioned by regulation plates arranged in a longitudinal stripe pattern, an example in Fig. 5B shows rectangular-shaped passing zones 25A sectioned by regulation plates arranged in a lateral stripe pattern, in Fig 5C square or rectangular-shaped passing zones 25A sectioned by regulation plates arranged in a grid pattern, in Fig 5D square or rectangular-shaped passing zones 25A sectioned by regulation plates arranged in a staggered grid pattern, in Fig 5E hexagonal-shaped passing zones 25A sectioned by regulation plates 25 with a honeycomb structure. Not being limited to the above examples, the shape of passing zone may be cylindrical or cone-shaped. Although the frames 10B and 10C of these examples are shown to be rectangular in shape, frames 10 B and 10C are preferably cylindrical in shape when the induction heating is used.

The organic material contained in the frame 10A is evaporated by using heat which is produced at the filler 21 by supplying an alternating current with a specific frequency (10Hz∼100kHz) to the heating coil 20. When the heating coil 20 is used as heating means, an amount of supplied current controls the heating state monitored with the magnetic probes 22.

The heating part 11 of the embodiments includes the vessels of the frame 10A accommodating the organic material B and the fillers 21 therein. Because these fillers 21 are disposed uniformly in the frame 10A, the organic material B is heated uniformly, so that the evaporation flow can be emitted uniformly in its density through an entire opening of the frame 10A.

The direction of the evaporation flow irradiated by the heating part 11 is regulated by the evaporation flow controller 12. Then, while the flow is going up through the evaporation flow controller 12, the flow is confined in the stacked frames 10A, 10B and 10C. The non-emitted evaporation flow can therefore be lastly collected in the frame 10A, and thus the high-cost organic materials can be used effectively without waste.

The evaporation flow A controlled by the evaporation flow controller 12 is emitted in almost the same directions to the substrate 3 of the deposition object, so that it becomes possible to form a thin film with high precision even when using a minute mask pattern. When the opening of the evaporation flow controller 12 is extended, it also becomes possible to form a thin film uniformly on a larger-area substrate.

Furthermore, because no useful organic material emits in the vacuum tank, it does not occur that the residual materials are mixed into a formed film to lower its quality, even when the different material is evaporated in the same vacuum tank.

The regulation plates 25 in an evaporation flow controller 12 or the frames 10B, 10C themselves are heated, so that the evaporated material adhering to these parts can also be recollected in the heating part 11.

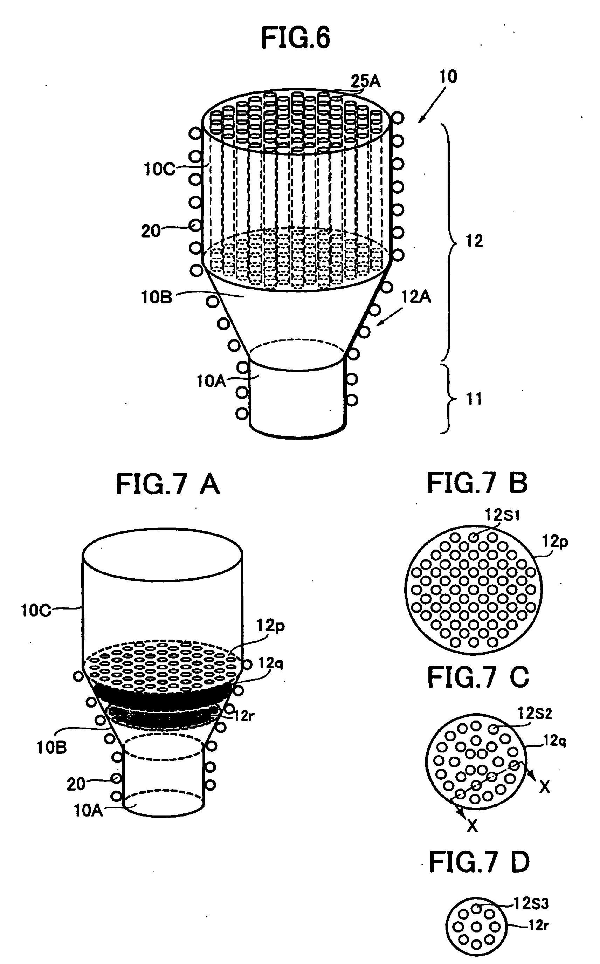

Fig. 6 shows the other embodiment of the present invention. The explanation will be given only for an evaporation source 10 hereinafter, and the other constructions of a vacuum evaporator are assumed to be the same described above. An evaporation source 10 of this example is constructed by cylindrical frames 10A, 10C and a cone-shaped frame 10B. Passing zones 25A in the frame 10C are cylindrical holes. A structure of a heating part 11 is the same as the above mentioned embodiment, and the structural material of an evaporation flow controller 12 is also the same as the above mentioned embodiment. A heating coil 20 is wound around the frames 10A, 10B, 10C to be heated by electromagnetic induction. The same parts of the embodiment mentioned above will not be explained repeatedly hereinafter.

The feature of this embodiment is that the frame 10B has an inverted truncated-conical shape and forms a uniformizing layer 12A. The uniformizing layer 12A changes a direction of an evaporation flow from the heating part randomly, so that a uniform evaporation flow density can be obtained through whole emitting region of the uniformizing layer 12A. The inverted conical shape enables an extension of the emitting region, to make a deposition on a large-area substrate easy.

Figs. 7A to 7D is a more specific example of embodiment of this uniformizing layer 12A. In this embodiment, distributing plates 12p, 12q and 12r are arranged in multi-stages in a frame 10B, which forms a uniformizing layer 12A. Fig. 7A shows an arrangement of distributing plates 12p, 12q and 12r. These distributing plates 12p, 12q and 12r are smaller in diameter step by step toward the upstream side, and arranged in parallel in the frame 10B. Each distributing plate 12p, 12q and 12r has a plurality of openings 12s1, 12s2 and 12s3 thereon, respectively. Although these openings need not be circles or uniform sizes, it is preferable that the positions of the respective openings do not coincide in the multi-stage (3 stage) arrangement of the distributing plates. When distributing plates are formed out of material generating heat by electromagnetic induction, these holes of plates are prevented from being blocked by heating.

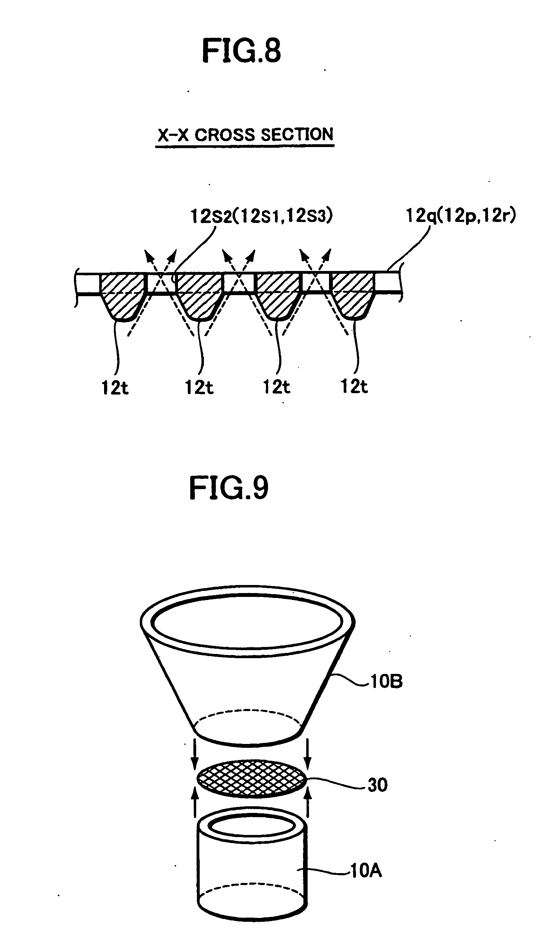

Fig. 8 is a cross sectional view (X-X cross section) of the distributing plate 12q (12p, 12r). The distributing plate 12q (12p, 12r) has guide projections 12t projecting toward the upstream side and openings 12s2 (12s1, 12s3) formed between the adjacent guide projections 12t. Each guide projection 12t tapers to guide an evaporation flow to openings 12s2 (12s1, 12s3), and so changes a direction of the evaporation flow randomly. Because the evaporation flow is changed randomly in direction every passing through the distributing plates 12p, 12q and 12r, a uniform density of the evaporation flow can be obtained through the whole emitting region of the uniformizing layer 12A.

The vacuum evaporator of these embodiments allows a film to be formed uniformly from its center to the periphery when employing a wide emitting opening of the evaporation source 10 for adapting it to a larger-area substrate.

Fig. 9 is an explanatory view explaining the other embodiment of the present invention. This example employs a big cluster of molecule capturing body 30 placed between a frame 10A and a frame 10B of an evaporation source 10. It is effective for the big cluster of molecule capturing body 30 to be placed just upon the frame 10A serving as a heating part 11, while the big cluster of molecule capturing body 30 may be placed anywhere between layers of a stacked frame structure. The evaporation source 10 of this invention is formed out of the stacked frame structure, thus the big cluster of molecule capturing body 30 can be disposed easily with a simple structure between the layers of the stacked frame structure.

The big cluster of molecule capturing body 30, which is formed out of a meshed metallic material capable of producing heat by electromagnetic induction, catches a big cluster of molecule of a deposition material radiated from the heating part 11. When a deposition rate is increased by high-temperature heating of the heating part 11, splashes, which are granular emissions of the deposition material from the heating part 11, also increase. Adherence of this granular deposition material to a substrate lowers a quality of a thin film because of decreasing a uniformity of the thin film. For preventing this, the big cluster of molecule capturing body 30 is provided to catch the granular deposition materials, and the captured granular materials can be recollected into the heating part 11 by heating of the big cluster of molecule capturing body 30.

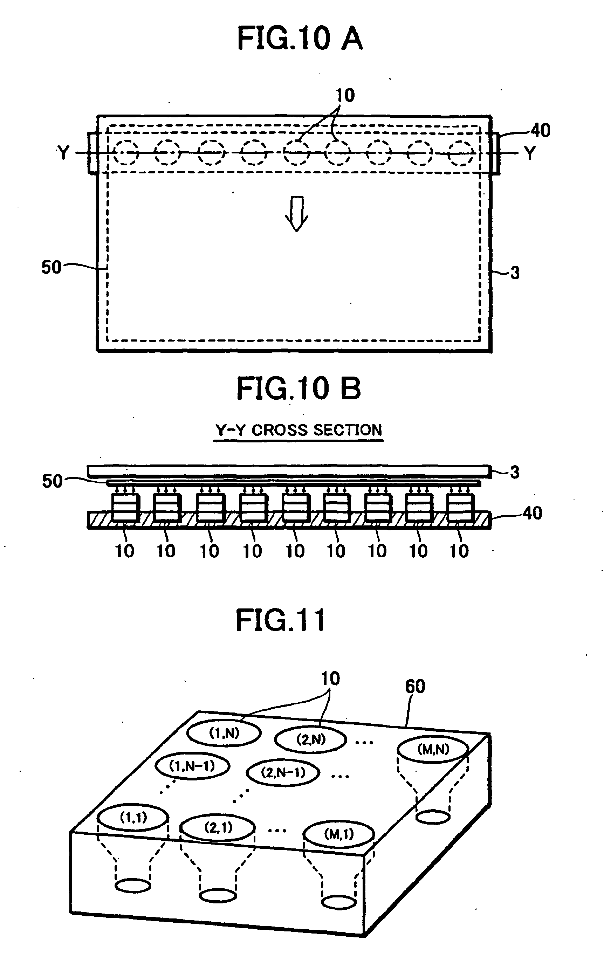

Fig. 10A and 10B show an example of a vacuum evaporator for evaporating a large-area substrate using the evaporation source 10 of the embodiment described above. An evaporation source aggregation 40 is formed with a plurality of evaporation sources 10 arranged in a line, and transfer means is provided for transferring the evaporation source aggregation 40 perpendicularly to its arrangement line (a direction of the arrow shown in Fig. 10A) to evaporate an entire substrate 30 through a shadow-mask. Deposition on the entire substrate can be done through moving the evaporation source aggregation 40, so that evaporation time can be shortened.

Fig. 11 shows another example of a vacuum evaporator for evaporation of a large-area substrate using the evaporation source 10 of the embodiment described above. An evaporation source aggregation 60, in this example, is composed of a plurality of evaporation sources 10 arranged in a matrix form on a plane, to evaporate a large-area substrate just once. Evaporation sources 10 need not be arranged in a dense form, but may be arranged at an appropriate interval in consideration of a spread of an evaporation flow. Deposition on the entire substrate can be done by one process using the evaporation source aggregation 60 with M x N pieces of evaporation sources 10, and evaporation time can therefore be shortened remarkably.

In the embodiments shown in Figs. 10A and 11, a heating coil 20 may be provided for each evaporation source or for the whole of the evaporation source aggregation 40 or 60. When the heating coil 20 is provided for each evaporation source 10, the heated state of each evaporation source can be controlled individually, therefore it becomes possible to partially form a thin film with a required quality on a large-area substrate.

The vacuum evaporators of these embodiments are effective in manufacture of an organic EL display panel, particularly an organic EL display panel on a large-area substrate. The organic EL display panel is formed out of organic thin films such as a hole transfer layer, a light-emitting layer and an electron transport layer arranged between an anode and a cathode. An organic material evaporated in the vacuum evaporators of embodiments of the present invention is at least one sort of organic material for formation of these organic thin films.

Above mentioned organic materials used in the vacuum evaporators of embodiments of the present invention involve materials forming hole transfer layers, such as tris(8-quinolinolato)aluminum complex, bis(benzoquinolinolato)beryllium complex, tri(dibenzoylmethyl)phenanthoroline europium complex, and materials forming electron transport layers, such as 1,3,4-oxazole derivative, 1,2,4-triazole derivative. Materials are not confined in the above-mentioned materials, but any material for forming functional layers on an organic EL display panel is applicable. The vacuum evaporators of these embodiments are also available to a precise control of an evaporation flow in a multi-material deposition being needed for a manufacture of a color display panel.

Instead of providing the heating coil 20 around the whole of the evaporation source 10 as described above, the heating coil 20 may be provided only around the frame of a heating part 11, and the other frames of the evaporation source 10 may be heated using the heat conduction from the heating part 11. The evaporation source 10 of the above embodiments is formed out of a stacked frame structure, then rapid heat conduction is achieved from the heating part 11 to the evaporation flow controller 12.

Instead of providing one heating coil 20 around the whole of the evaporation source 10 as mentioned above, it is possible to provide one heating coil for each frames 10A, 10B and 10C, respectively, for controlling the heated state of the frame 10A, 10B and 10C corresponding to each function individually. In this case, the magnetic probe 22 described above will be provided in each frame 10A, 10B and 10C.

The embodiments of the present invention explained above exhibit the following features; (1) an improvement in utilization efficiency of the deposition materials, (2) an enhancement in qualities of the thin films being formed, and (3) a uniform deposition on a larger-area substrate.

While there has been described what are at present considered to be preferred embodiments of the present invention, it will be understood that various modifications may be made thereto, and it is intended that the appended claims cover all such modifications as fall within the of the invention.

## Claims

1. A vacuum evaporator having a vacuum tank (1), a holder (4) of a deposition object (3), at least one evaporation source (10) accommodating organic material (B), a vacuum pump (6), and a valve (5), the holder (4) and the evaporation source (10) being disposed in the vacuum tank (1),
wherein the evaporation source (10) comprises:
- a heating part (11) for heating and evaporating the accommodated organic material (B); and
- an evaporation flow controller (12) for controlling a direction of an evaporation flow (A) from the evaporation source (10) to the deposition object (3), the evaporation flow (A) being generated by heating the organic material (B);
- wherein the evaporation source (10) is formed with a consecutively stacked frame structure (10A - 10C), a bottom frame (10A) of which serves as the heating part (11), and the other frames (10B, 10C) of the stacked frame structure (10A - 10C) serve as the evaporation flow controller (12).

2. The vacuum evaporator according to claim 1,
wherein the evaporation flow controller (12) comprises a uniformizing layer (12A), which is located at the uppermost stream, for uniformizing the evaporation flow (A) in the entire region from the heating part (11) to the deposition object (3).

3. The vacuum evaporator according to claim 2,
wherein the uniformizing layer (12a) includes a distributing plate (12p, 12q, 12r) having a plurality of guide projections (12t) for changing over the direction of the evaporation flow (A) and a plurality of openings (12s₁, 12s₂, 12s₃), for passing the evaporation flow (A) therethrough, formed between the guide projections (12t) adjacent to each other.

4. The vacuum evaporator according to claim 3,
wherein the uniformizing layer (12A) forms a conical frame (10B) with a width spreading along a downstream direction of the evaporation flow (A),
and wherein the distributing plates (12p, 12q, 12r) are arranged in multi stages in the uniformizing layer (12A).

5. The vacuum evaporator according to any one of claims 2 to 4,
wherein the uniformizing layer (12A) is formed out of a material adapted to be heated by the heating part (11).

6. The vacuum evaporator according to any one of claims I to 5,
wherein the evaporation flow controller (12) includes an evaporation flow regulation layer having a plurality of passing zones (25A) sectioned by regulation plates (25).

7. The vacuum evaporator according to claim 6,
wherein at least one part of the regulation plates (25) is formed out of material capable of being heated by the heating part (11).

8. The vacuum evaporator according to any one of claims 1 to 7,
wherein the heating part (11) accommodates the organic material (B) and fillers (21) therein, the fillers (21) being formed out of material adapted to be heated by electromagnetic induction,
and wherein the heating part (11) includes a heater (20) for heating the organic material (B) and the fillers (21) by electromagnetic induction.

9. The vacuum evaporator according to any one of claims 1 to 8,
further comprising a meshed big cluster of a molecule capturing body (30) formed out of material capable of being heated, which is disposed between the heating part (11) and the evaporation flow controller (12), or between the respective frames of the evaporation flow controller (12).

10. The vacuum evaporator according to any one of claims I to 9,
wherein the plurality of evaporation sources (10) are arranged on a plane.

11. The vacuum evaporator according to any one of claims 1 to 9,
wherein the plurality of evaporation sources (10) are linearly arranged in parallel, and
wherein the vacuum evaporator further comprises a transfer section for transferring any one of the evaporation sources (10) and the deposition object (3) in a direction perpendicular to the linear arrangement of the evaporation sources (10).

12. A method of manufacturing an organic EL display panel with organic thin films deposited between a pair of electrodes, any one of which is formed on a surface of a substrate (3),
**characterized by** using a vacuum evaporator comprising an evaporation source (10) formed out of consecutively stacked frames (10A - 10C), a bottom frame (10A) of which serves as a heating part (11) for accommodating an organic material (B) and evaporating the organic material (B) by heating, and the other frames (10B, 10C) of which serve as an evaporation flow controller (12) for controlling a direction of the evaporation flow (A) from the heating part (11) to the substrate (3).

13. The method according to claim 12,
wherein the evaporation flow controller (12) includes a uniformizing layer (12A), which is located at the uppermost stream, for uniformizing the evaporation flow (A) in the entire region from the heating part (11) to the substrate (3).

14. The method according to claim 12 or 13,
wherein the heating part (11) accommodates the organic material (B) and fillers (21) therein, the fillers (21) being formed out of material adapted to be heated by electromagnetic induction,
and wherein the heating part (11) includes a heater (20) for heating the organic material (B) and the fillers (21) by electromagnetic induction.

## Patentansprüche

1. Vakuumverdampfer, der folgendes aufweist:
einen Vakuumbehälter (1), einen Halter (4) für einen zu bedampfenden Gegenstand (3), mindestens eine Verdampfungsquelle (10), in der ein organisches Material (B) aufgenommen ist, eine Vakuumpumpe (6) und ein Ventil (5), wobei der Halter (4) und die Verdampfungsquelle (10) in dem Vakuumbehälter (1) angeordnet sind,
wobei die Verdampfungsquelle (10) folgendes aufweist:
- eine Heizeinheit (11) zum Erwärmen und Verdampfen des aufgenommenen organischen Materials (B);
- eine Verdampfungsströmungs-Steuerung (12) zum Steuern der Richtung einer Verdampfungsströmung (A) von der Verdampfungsquelle (10) zu dem zu bedampfenden Gegenstand (3), wobei die Verdampfungsströmung (A) durch Erwärmen des organischen Materials (B) erzeugt wird;
- wobei die Verdampfungsquelle (10) mit einer aufeinander folgend gestapelten Rahmenkonstruktion (10A - 10C) ausgebildet ist, von der ein unterer Rahmen (10A) als Heizeinheit (11) dient, wobei die anderen Rahmen (10B, 10C) der gestapelten Rahmenkonstruktion (10A - 10C) als Verdampfungsströmungs-Steuerung (12) dienen.

2. Vakuumverdampfer nach Anspruch 1,
wobei die Verdampfungsströmungs-Steuerung (12) eine in der obersten Strömung befindliche Vereinheitlichungsschicht (12A) zum Vergleichmäßigen der Verdampfungsströmung (A) in dem gesamten Bereich von der Heizeinheit (11) bis zu dem zu bedampfenden Gegenstand (3) aufweist.

3. Vakuumverdampfer nach Anspruch 2,
wobei die Vereinheitlichungsschicht (12A) eine Verteilerplatte (12p, 12q, 12r) beinhaltet, die eine Vielzahl von Führungsvorsprüngen (12t) zum Ändern der Richtung der Verdampfungsströmung (A) und eine Vielzahl von zwischen den einander benachbarten Führungsvorsprüngen (12t) ausgebildeten Öffnungen (12s₁, 12s₂, 12s₃) zum Hindurchführen der Verdampfungsströmung (A) durch diese aufweist.

4. Vakuumverdampfer nach Anspruch 3,
wobei die Vereinheitlichungsschicht (12A) einen konischen Rahmen (10B) mit einer Breite bildet, die entlang der strömungsabwärtigen Richtung der Verdampfungsströmung (A) zunimmt, und
wobei die Verteilerplatten (12p, 12q, 12r) in mehreren Stufen in der Vereinheitlichungsschicht (12A) angeordnet sind.

5. Vakuumverdampfer nach einem der Ansprüche 2 bis 4,
wobei die Vereinheitlichungsschicht (12A) aus einem Material gebildet ist, das für ein Erwärmen durch die Heizeinheit (11) ausgelegt ist.

6. Vakuumverdampfer nach einen der Ansprüche 1 bis 5,
wobei die Verdampfungsströmungs-Steuerung (12) eine Verdampfungsströmungs-Regulierschicht mit eine Vielzahl von Durchlaßzonen (25A) aufweist, die durch Regulierplatten (25) unterteilt sind.

7. Vakuumverdampfer nach Anspruch 6,
wobei mindestens eine der Regulierplatten (25) aus einem Material gebildet ist, das für ein Erwärmen durch die Heizeinheit (11) ausgelegt ist.

8. Vakuumverdampfer nach einem der Ansprüche 1 bis 7,
wobei die Heizeinheit (11) das organische Material (B) und Füllstoffe (21) aufnimmt, wobei die Füllstoffe (21) aus einem Material gebildet sind, das sich durch elektromagnetische Induktion erwärmen läßt, und
wobei die Heizeinheit (11) eine Heizeinrichtung (20) zum Erwärmen des organischen Materials (B) und der Füllstoffe (21) durch elektromagnetische Induktion aufweist.

9. Vakuumverdampfer nach einem der Ansprüche 1 bis 8,
weiterhin mit einem gitterartigen Körper (30) zum Auffangen einer großen Molekülansammlung, der aus einem Material gebildet ist, das sich erwärmen läßt, und der zwischen der Heizeinheit (11) und der Verdampfungsströmungs-Steuerung (12) oder zwischen den jeweiligen Rahmen der Verdampfungsströmungs-Steuerung (12) angeordnet ist.

10. Vakuumverdampfer nach einem der Ansprüche 1 bis 9,
wobei die Vielzahl der Verdampfungsquellen (10) in einer Ebene angeordnet sind.

11. Vakuumverdampfer nach einem der Ansprüche 1 bis 9,
wobei die Vielzahl der Verdampfungsquellen (10) linear parallel angeordnet sind, und
wobei der Vakuumverdampfer ferner einen Transferbereich zum Transferieren von einer beliebigen der Verdampfungsquellen (10) und des zu bedampfenden Gegenstands (3) in einer zu der linearen Anordnung der Verdampfungsquellen (10) rechtwinkligen Richtung aufweist.

12. Verfahren zum Herstellen eines organischen EL-Anzeigeschirms mit organischen Dünnschichten, die zwischen einem Paar Elektroden aufgebracht sind und die jeweils auf einer Oberfläche eines Substrats (3) gebildet sind,
**gekennzeichnet durch**
die Verwendung eines Vakuumverdampfers, der eine Verdampfungsquelle (10) aufweist, die aus aufeinander folgend gestapelten Rahmen (10A - 10C) gebildet ist, von denen ein unterer Rahmen (10A) als Heizeinheit (11) zum Aufnehmen eines organischen Materials (B) und zum Verdampfen des organischen Materials (B) **durch** Erwärmung dient und von denen andere Rahmen (10B, 10C) als Verdampfungsströmungs-Steuerung (12) zum Steuern der Richtung der Verdampfungsströmung (A) von der Heizeinheit (11) zu dem Substrat (3) dienen.

13. Verfahren nach Anspruch 12,
wobei die Verdampfungsströmungs-Steuerung (12) eine in der obersten Strömung befindliche Vereinheitlichungsschicht (12A) zum Vergleichmäßigen der Verdampfungsströmung (A) in dem gesamten Bereich von der Heizeinheit (11) bis zu dem Substrat (3) aufweist.

14. Verfahren nach Anspruch 12 oder 13,
wobei die Heizeinheit (11) das organische Material (B) und Füllstoffe (21) aufnimmt, wobei die Füllstoffe (21) aus einem Material gebildet sind, das sich durch elektromagnetische Induktion erwärmen läßt, und
wobei die Heizeinheit (11) eine Heizeinrichtung (20) zum Erwärmen des organischen Materials (B) und der Füllstoffe (21) durch elektromagnetische Induktion aufweist.

## Revendications

1. Évaporateur à vide comprenant un réservoir à vide (1), un support (4) pour un objet à déposer (3), au moins une source d'évaporation (10) contenant un matériau organique (B), une pompe à vide (6), et une valve (5), le support (4) et la source d'évaporation (10) étant disposés dans le réservoir à vide (1),
dans lequel la source d'évaporation (10) comprend :
-- une partie de chauffage (11) pour chauffer et faire évaporer le matériau organique contenu (B) ; et
-- un contrôleur de flux d'évaporation (12) pour contrôler une direction d'un flux d'évaporation (A) provenant de la source d'évaporation (10) vers l'objet à déposer (3), le flux d'évaporation (A) étant généré en chauffant le matériau organique (B) ;
-- dans lequel la source d'évaporation (10) est formée par une structure en cadres empilés consécutivement (10A-10C), dont un cadre inférieur (10A) sert de partie de chauffage (11), et les autres cadres (10B, 10C) de la structure en cadres empilés (10A-10C) servent de contrôleur de flux d'évaporation (12).

2. Évaporateur à vide selon la revendication 1,
dans lequel le contrôleur de flux d'évaporation (12) comprend une couche d'uniformisation (12A), qui est située au niveau de l'écoulement le plus en haut, pour uniformiser le débit d'évaporation (A) dans la région entière de la partie de chauffage (11) vers l'objet à déposer (3).

3. Évaporateur à vide selon la revendication 2,
dans lequel la couche d'uniformisation (12a) inclut une plaque de distribution (12p, 12q, 12r) ayant une pluralité de projections de guidage (12t) pour inverser la direction du flux d'évaporation (A) et une pluralité d'ouvertures (12s₁, 12s₂, 12s₃) pour faire passer le flux d'évaporation (A) à travers celles-ci, formées entre les projections de guidage (12 type est fait parenthèses adjacentes une à l'autre.

4. Évaporateur à vide selon la revendication 3,
dans lequel la couche d'uniformisation (12A) forme un cadre conique (10B) avec une largeur qui s'étend le long d'une direction aval du flux d'évaporation (A), et dans lequel les plaques de distribution (12p, 12q, 12r) sont agencées suivants des étages multiples dans la couche d'uniformisation (12A).

5. Évaporateur à vide selon l'une quelconque des revendications 2 à 4,
dans lequel la couche d'uniformisation (12A) est formée en un matériau adapté à être chauffé par la partie de chauffage (11).

6. Évaporateur à vide selon l'une quelconque des revendications 1 à 5,
dans lequel le contrôleur de flux d'évaporation (12) inclut une couche de régulation de flux d'évaporation ayant une pluralité de zones passantes (25A) recoupées par des plaques de régulation (25).

7. Évaporateur à vide selon la revendication 6,
dans lequel au moins une partie des plaques de régulation (25) est formée en un matériau capable d'être chauffé par la partie de chauffage (11).

8. Évaporateur à vide selon l'une quelconque des revendications 1 à 7,
dans lequel la partie de chauffage (11) contient à l'intérieur le matériau organique (B) et des charges (21), les charges (21) étant formées en un matériau adapté à être chauffé par induction électromagnétique, et
dans lequel la partie de chauffage (11) inclut un élément chauffant (20) pour chauffer le matériau organique (B) et les charges (21) par induction électromagnétique.

9. Évaporateur à vide selon l'une quelconque des revendications 1 à 8,
comprenant en outre un amas grillagé de grande taille d'un corps (30) de capture de molécules, formé en un matériau capable d'être chauffé, qui est disposé entre la partie de chauffage (11) et le contrôleur de flux d'évaporation (12), ou entre les cadres respectifs du contrôleur de flux d'évaporation (12).

10. Évaporateur à vide selon l'une quelconque des revendications 1 à 9,
dans lequel la pluralité de sources d'évaporation (10) sont agencées sur un plan.

11. Évaporateur à vide selon l'une quelconque des revendications 1 à 9,
dans lequel la pluralité de sources d'évaporation (10) sont agencées linéairement en parallèle, et
dans lequel l'évaporateur à vide comprend en outre une section de transfert pour transférer l'un quelconque des éléments parmi les sources d'évaporation (10) et l'objet à déposer (3) dans une direction perpendiculaire à l'agencement linéaire des sources d'évaporation (10).

12. Procédé pour fabriquer un panneau d'affichage électroluminescent organique avec des films minces organiques déposés entre une paire d'électrodes, l'un quelconque de ces films étant formé sur une surface d'un substrat (3),
**caractérisé en ce qu'**on utilise un évaporateur à vide qui comprend une source d'évaporation (10) formée par des cadres empilés consécutivement (10A-10C), dont un cadre inférieur (10A) sert de partie de chauffage (10) pour contenir un matériau organique (B) et faire évaporer le matériau organique (B) par chauffage, et dont les autres cadres (10B, 10C) servent de contrôleur de flux d'évaporation (12) pour contrôler une action du flux d'évaporation (A) depuis la partie de chauffage (11) vers le substrat (3).

13. Procédé selon la revendication 12,
dans lequel le contrôleur de flux d'évaporation (12) inclut une couche d'uniformisation (12A), qui est située au niveau du courant le plus haut, pour uniformiser le flux d'évaporation (A) dans la région entière depuis la partie de chauffage (11) jusqu'au substrat (3).

14. Procédé selon la revendication 12 ou 13,
dans lequel la partie de chauffage (11) contient le matériau organique (B) et des charges (21) à l'intérieur, les charges (21) étant formées en un matériau adapté à être chauffé par induction électromagnétique, et
dans lequel la partie de chauffage (11) inclut un élément chauffant (20) pour chauffer le matériau organique (B) et les charges (21) par induction électromagnétique.
